# EUROPEAN PATENT SPECIFICATION

(11) **EP 1 849 993 B1**
(45) Date of publication and mention of the grant of the patent: **18.08.2010**
(21) Application number: 06252206.5
(22) Date of filing: 25.04.2006
(51) Int. Cl.: F02M 51/06, H01L 41/053

(54) **Protective encapsulation**
Schutzverkapselung
Encapsulation protective

(43) Date of publication of application: 31.10.2007
(73) Proprietor: Delphi Technologies Holding S.à.r.l., 4940 Bascharage (LU)
(72) Inventor: Goat, Christopher, Gillingham, Kent ME8 0RU (GB); Kiefer, Joachim c/o Delphi Tech. Centre-Luxembourg, 4940 Bascharage (LU)
(74) Representative: Gregory, John David Charles

(56) References cited:
- EP-A- 0 799 991
- DE-A1- 19 929 711
- JP-A- 2 192 186
- US-A- 4 471 256
- US-B1- 6 520 423
- PATENT ABSTRACTS OF JAPAN vol. 016, no. 192 (E-1199), 11 May 1992 (1992-05-11) & JP 04 026168 A (NEC CORP), 29 January 1992 (1992-01-29)
- PATENT ABSTRACTS OF JAPAN vol. 014, no. 354 (E-0958), 31 July 1990 (1990-07-31) & JP 02 123796 A (OMRON TATEISI ELECTRON CO), 11 May 1990 (1990-05-11)
- PATENT ABSTRACTS OF JAPAN vol. 2002, no. 11, 6 November 2002 (2002-11-06) & JP 2002 188764 A (PIOLAX INC), 5 July 2002 (2002-07-05)

## Description

### TECHNICAL FIELD

This invention relates to methods of encapsulation to protect against permeation by fluids such as fuel and chemicals and/or water, and more particularly, but not exclusively, to the protection of piezoelectric actuators, for example for use in fuel injectors of internal combustion engines. The invention also concerns a piezoelectric actuator protected by encapsulation.

### BACKGROUND OF THE INVENTION

Known piezoelectric fuel injectors typically employ piezoelectric actuators made from a stack of piezoelectric ceramic discs or plates each connected to an electrode for electrically charging and discharging. The actuator is mechanically arranged for opening and closing an injector valve having a valve needle to meter fuel injected into the engine. Such piezoelectric actuators may be located in a chamber containing fuel at fuel injection pressure to control movement of the valve needle through a mechanical and/or hydraulic coupling. An example of a piezoelectric fuel injector is disclosed in the applicant's US Patent No. 6,520,423, which utilises a hydraulic coupling to lift the valve needle off the valve seat to enable opening of the injector in response to longitudinal expansion of the piezoelectric actuator.

Piezoelectric ceramic multilayers are known in many designs. A common design aims to achieve the greatest longitudinal strain, and hence longitudinal movement, by having the maximum piezoelectrically active cross section. To achieve this, the internal electrodes of both polarities are exposed on two of the piezoelectric element faces. The high electrical field applied to the element to achieve high strain means there is a risk of shorting between the internal electrodes of opposite polarity. To prevent such surface breakdown, the exposed electrode faces of the piezoelectric multilayer element are preferably covered with a passivation material, usually of silicone rubber.

Passivation of the piezoelectric element potentially provides a long-term barrier to surface shorting whilst it remains in a dry and fuel free environment. However, when exposed to fuel and/or moisture the passivation material can lose its dielectric strength leading to failure so that it no longer fulfils its intended purpose. It is therefore highly desirable that a barrier is applied over the piezoelectric element and passivation layer to prevent fuel and water entry.

The applicant has experimented with a number of methods of encapsulating piezoelectric stacks covered with a passivation material, attempting to reduce the permeation of fuel and/or water. One method currently being investigated by the applicant to achieve this function is the use of a polymeric heat shrink material made out of a fluoropolymer. Alternatively, it has been proposed to overmould the piezoelectric actuator with a thermoplastic polymer.

In a further method, it has been proposed to use a metal tube around the piezoelectric actuator. While this concept would provide a barrier to fuel and moisture, it is difficult to provide adequate end sealing and to ensure that no unfilled space is left between the passivation material and the metal tube.

Against this background, the main object of the present invention is to provide an alternative method of encapsulation that, when applied to a piezoelectric actuator, greatly reduces fuel (diesel/gasoline) and water permeation and thus improves the lifetime of piezoelectrically driven injectors.

### SUMMARY OF THE INVENTION

To this end, and from one aspect, the present invention resides in a method of protecting a piezoelectric actuator according to claim 1.

The shape memory metallic material tube is manufactured prior to the encapsulation process. For example, it may be made mainly by machining to its final dimensions with a tolerance of less than 50 microns to form an original shape memory metallic tube that can be used to encapsulate the piezoelectric stack. Advantageously, the machined shape memory metallic tube has a wall thickness of less than one millimetre and preferably between about 200 to 500 microns.

When the original shape memory metallic tube is plastically deformed below its transformation temperature, for example by inserting a mandrel into the tube to stretch the tube, such that the inner tube area becomes larger than the actual piezoelectric stack surface area, thus allowing the tube to be placed over and cover the stack and anywhere else necessary to isolate the passivation material. Stretching the tube by about 4% from its original shape will usually be sufficient to permit insertion of the stack.

By heating the deformed shape memory metallic tube, on the piezoelectric stack, above its transformation temperature, for example to approximately 220°C, the tube recovers its original shape. After heating, the metallic tube fits to the dimensions of the passivated piezoelectric stack and preferably also its end pieces, effectively hermetically sealing the tube on to the end pieces.

In a preferred embodiment, the size of the tube is selected so that the stress on the actuator parts is very small, except in the region of the end pieces where it is necessary to ensure effective sealing. Alternatively, the low stress state on the passivation material may be achieved through the precise composition of the shape memory material and its transformation temperature. Generally, the transformation temperature is a function of the alloy type, composition and also of the thermomechanical treatments applied.

It is preferred that the transformation temperature be such that the shape memory material remains in its austenitic state under the typical operating temperatures encountered by the actuator within the fuel injector. In this regard, the shape memory alloy transformation temperature is preferably outside the range of - 40°C to 150° C.

Rather than the shape memory alloy transformation temperature being above the upper operating temperature range, an alternative is to ensure the transformation temperature is below the lowest operating temperature, so that the shape memory alloy remains in its austenitic state during service.

For improving sealing around the ends of the piezoelectric stack, an adhesive or elastomeric layer may be used between the sealing surfaces of the end pieces and the shape memory metallic tube. This additional sealant phase may, for example, be applied on the surface of the end pieces or in channels around the sealing surface.

The invention also resides in a piezoelectric actuator encapsulated by a shape memory metallic material according to any of the previously described methods to protect against permeation by injurious fluids such as fuel (diesel/gasoline) and water.

The present invention also resides in a fuel injector incorporating a piezoelectric actuator as described above.

By means of the shape memory metallic material encapsulation of this invention, which acts as a fuel/moisture barrier, permeation by fuel (diesel/gasoline) and water is greatly reduced and the lifetime of piezoelectric driven injectors is increased.

Moreover, in comparison to the above presented prior art proposals, the invention provides the advantage that permeation by fuel and water is effectively prevented due to the metallic nature of the shape memory material and the bulk thickness of the encapsulation material. Furthermore, the use of a shape memory metallic material in accordance with the invention permits a greater freedom with regard to size and thus sealing options.

The shape memory metallic material can be any appropriate metallic material consistent with achieving a suitable reduction in permeation by diesel or gasoline fuel and water and is preferably a shape memory alloy.

For example, the shape memory alloy may be a nickel titanium alloy such as that manufactured by Johnson Matthey under the trade name NITINOL (Nickel Titanium Naval Ordnance Laboratory). Alloying additions such as iron may be included in order to modify the transformation temperature of the shape memory alloy. Other shape memory alloys based on copper may be used, but nickel titanium alloys are preferred for their super-elastic shape memory characteristics.

All shape memory metallic encapsulation materials of this invention provide an impermeable barrier to diesel/gasoline fuels and water and can be used as encapsulation materials for piezoelectric actuators for direct injection engines of diesel as well as gasoline fuel types.

In order that the invention may be more readily understood, some embodiments in accordance therewith will now be described, by way of example, with reference to the accompanying drawings, in which:-

### BRIEF DESCRIPTION OF THE DRAWINGS

Figure 1 is a cross-sectional view of a piezoelectric actuated fuel injector like that disclosed in US Patent No. 6,520,423 and including a piezoelectric actuator comprising a stack of piezoelectric elements;
Figure 2 shows schematically a multilayer piezoelectric element before and after passivation; and
Figure 3 shows schematically a succession of steps in a method of producing a protective encapsulation of a piezoelectric actuator in accordance with an embodiment of the invention.

### DESCRIPTION OF THE PREFERRED EMBODIMENT

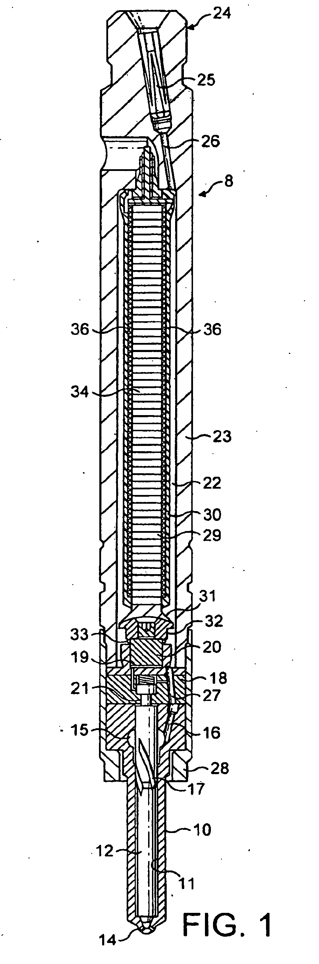

A known piezoelectric actuated fuel injector 8 is depicted in Fig.1. The fuel injector 8 generally includes an injector body 10 having an axially extending fuel passage 11, an injector valve 12 axially moveable within the fuel passage 11, a piezoelectric element 29 for actuating the injector valve 12, and a hydraulic assembly 18 for interfacing between the piezoelectric element 29 and the injector valve 12, where the longitudinal expansion of the piezoelectric element 29 axially separates the injector valve 12 from its seating, thereby allowing fuel flow from the fuel injector.

The piezoelectric actuator 29 is located within the accumulator 22 and comprises a stack of piezoelectric discs 34 with external electrodes 36. The piezoelectric element of the actuator 29 is overmoulded with a thermoplastic polymer coating 30 to restrict the ingress of fuel into the joints between the individual elements forming the actuator 29.

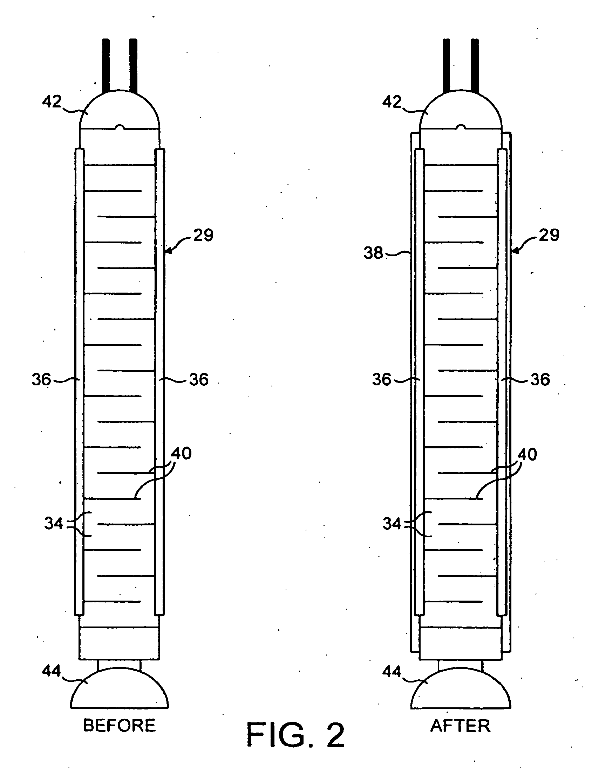

As shown schematically in the before and after diagrams of Figure 2, the electrodes 36 of the piezoelectric actuator 29 may be protected by a passivation material 38.

In particular, the piezoelectric actuator 29 comprises a multilayer piezoelectric element made up of piezoelectric discs 34 interdigitated with electrodes 40. External electrodes 36 provide the electrical contact between electrodes 40 and the top end-piece 42. Top end-piece 42 at the upper end of the stack incorporates the combined electrical connection and seal to the injector body (not shown) and at the opposite end is lower end seal 44 which couples to the motion amplifier (not shown). A passivation material 38 such as silicone rubber is then applied to cover both the exposed faces of electrodes 40 and the external electrodes 36.

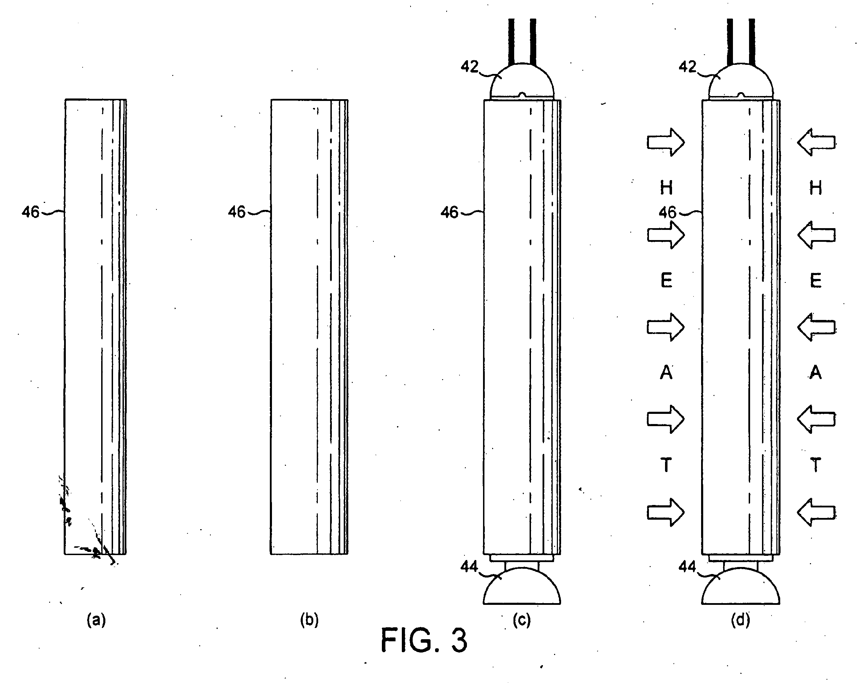

In the prior art, after passivation, the piezoelectric actuator 29 may then be subjected to further treatment, such as overmoulding with a polymer. However, none of the known polymer coatings has proved entirely reliable in terms of preventing ingress of fuel and/or water into the actuator. Hence, instead of overmoulding with a thermoplastic polymer coating 30 as shown in Figure 1, the actuator 29 may be encapsulated in a shape memory alloy as shown schematically in Figure 3.

Specifically, step (a) shows a shape memory alloy tube 46 made to a specified length and diameter appropriate to fit closely around the passivated piezoelectric stack of Figure 2. Once the shape memory alloy tube 46 has been machined to the correct dimensions, it is then stretched over a mandrel (not shown) which has a larger external diameter than that of the internal diameter of the manufactured tube 46 as shown in step (b).

The stretched shape memory alloy tube 46 is then removed from the mandrel whereupon it is of sufficiently large diameter to be slipped over the passivated stack as shown in step (c). Once in position on the passivated stack, with all of the passivation layer covered, heat is applied to the exterior of the stretched shape memory alloy tube 46 as shown in step (d). The heat should be sufficient to raise the temperature of the tube 46 to the alloy's transformation temperature whereupon it returns to its original manufactured shape and consequently fits tightly around the passivated stack. In this way, it is possible to exclude any fuel and/or water from penetrating through to the passivation layer when the actuator is in situ surrounded by pressurized fuel.

## Claims

1. A method of protecting a piezoelectric actuator (29) for use in a fuel injection system against permeation by injurious fluids, such as fuel and water, said method including:
providing a piezoelectric actuator that is connected to first and second end pieces (42, 44), the first end piece (42) for providing an electrical connection and/or a seal to a fuel injector body;
forming a shape memory metallic material (46) as a tube having an internal diameter substantially similar to the external diameter of the piezoelectric actuator (29) prior to encapsulation;
deforming the shape memory metallic tube (46) below its transformation temperature to an internal diameter greater than the piezoelectric actuator (29);
placing the deformed tube (46) over the piezoelectric actuator (29); and
heating the tube (46) to above its transformation temperature such that the tube (46) reverts to its original shape and encapsulates the piezoelectric actuator (29) and seals the shape memory metallic material (46) to the end pieces (42, 44).

2. A method according to claim 1, comprising machining the shape memory metallic material (46) to the required dimensions.

3. A method according to claim 2, comprising machining the shape memory metallic material (46) to a wall thickness of about 1 mm or less.

4. A method according to claim 3, comprising machining the shape memory metallic material (46) to a wall thickness of about 200 to 500 microns.

5. A method according to claim 1, comprising stretching the tube (46) around a mandrel to increase the internal diameter of the tube.

6. A method according to claim 1 or claim 5, comprising stretching the tube (46) to increase the internal diameter by about 4% before being placed over the piezoelectric actuator (29).

7. A method according to claim 1, wherein the piezoelectric actuator (29) is passivated and wherein by encapsulating the piezoelectric actuator the shape memory metallic material (46) isolates the passivation (38).

8. A method according to any one of claims 1 to 7, comprising applying a sealant between the end pieces and the shape memory metallic material (46).

9. A method according to any one of claims 1 to 8, wherein the shape memory metallic material (46) is a shape memory metallic alloy.

10. A method according to claim 9, wherein the shape memory metallic material (46) is a nickel titanium alloy such as NITINOL™.

11. A piezoelectric actuator (29) encapsulated by a shape memory metallic material (46) according to the method of any preceding claim.

12. A fuel injector incorporating the piezoelectric actuator (29) according to claim 11.

## Patentansprüche

1. Verfahren zum Schutz eines piezoelektrischen Aktors (29) zur Verwendung in einer Kraftstoffeinspritzanlage vor Eindringung von schädlichen Fluiden, wie Kraftstoff und Wasser, wobei das genannte Verfahren Folgendes aufweist:
Bereitstellen eines piezoelektrischen Aktors, der mit einem ersten und einem zweiten Endstück (42, 44) verbunden ist, wobei das erste Endstück (42) zum Bereitstellen einer elektrischen Verbindung mit und/oder einer Abdichtung an dem Kraftstoffeinspritzdüsenkörper dient,
Gestalten eines Formgedächtnismetallmaterials (46) zu einem Rohr mit einem Innendurchmesser, der im Wesentlichen dem Außendurchmesser des piezoelektrischen Aktors (29) vor der Kapselung ähnlich ist,
Verformen des Formgedächtnismetallrohres (46) unter seiner Umwandlungstemperatur auf einen Innendurchmesser, der größer als der piezoelektrische Aktor (29) ist,
Aufstecken des verformten Rohres (46) auf den piezoelektrischen Aktor (29) und
Erhitzen des Rohres (46) auf über seine Umwandlungstemperatur, so dass das Rohr (46) seine ursprüngliche Form wiedereinnimmt und den piezoelektrischen Aktor (29) einkapselt und das Formgedächtnismetallmaterial (46) an den Endstücken (42, 44) abdichtet.

2. Verfahren nach Anspruch 1, umfassend das Bearbeiten des Formgedächtnismetallmaterials (46) auf die erforderlichen Dimensionen.

3. Verfahren nach Anspruch 2, umfassend das Bearbeiten des Formgedächtnismetallmaterials (46) auf eine Wandstärke von etwa 1 mm oder weniger.

4. Verfahren nach Anspruch 3, umfassend das Bearbeiten des Formgedächtnismetallmaterials (46) auf eine Wandstärke von etwa 200 bis 500 Mikrometer.

5. Verfahren nach Anspruch 1, umfassend das Dehnen des Rohres (46) um einen Dorn, um den Innendurchmesser des Rohres zu vergrößern.

6. Verfahren nach Anspruch 1 oder Anspruch 5, umfassend das Dehnen des Rohres (46) zum Vergrößern des Innendurchmessers um etwa 4 %, bevor es auf den piezoelektrischen Aktor (29) aufgesteckt wird.

7. Verfahren nach Anspruch 1, bei dem der piezoelektrische Aktor (29) passiviert wird und bei dem das Formgedächtnismetallmaterial (46) die Passivierung (38) durch Kapseln des piezoelektrischen Aktors isoliert.

8. Verfahren nach einem der Ansprüche 1 bis 7, umfassend das Auftragen eines Dichtmittels zwischen den Endstücken und dem Formgedächtnismetallmaterial (46).

9. Verfahren nach einem der Ansprüche 1 bis 8, bei dem das Formgedächtnismetallmaterial (46) eine Formgedächtnislegierung (46) ist.

10. Verfahren nach Anspruch 9, bei dem das Formgedächtnismetallmaterial (46) eine Nickel-TitanLegierung wie NITINOL™ ist.

11. Piezoelektrischer Aktor (29), der nach dem Verfahren eines der vorhergehenden Ansprüche mit einem Formgedächtnismetallmaterial (46) gekapselt ist.

12. Kraftstoffeinspritzdüse, die den piezoelektrischen Aktor (29) nach Anspruch 11 aufweist.

## Revendications

1. Procédé pour protéger un actionneur piézo-électrique (29) destiné à être utilisé dans un système d'injection de carburant à l'encontre d'une perméation de fluides nocifs, comme le carburant et l'eau, ledit procédé incluant les opérations consistant à :
fournir un actionneur piézo-électrique qui est connecté à une première et une seconde pièce terminale (42, 44), la première pièce terminale (42) pour assurer une connexion électrique et/ou un étanchement avec un corps injecteur de carburant ;
former un matériau métallique à mémoire de forme (46) comme un tube ayant un diamètre interne sensiblement similaire au diamètre externe de l'actionneur piézo-électrique (29) avant encapsulation ;
déformer le tube métallique à mémoire de forme (46) au-dessous de sa température de transformation à un diamètre interne supérieur à l'actionneur piézo-électrique (29) ;
placer le tube déformé (46) par-dessus l'actionneur piézo-électrique (29) ; et
chauffer le tube (46) au-dessus de sa température de transformation de telle façon que le tube (46) revient à sa forme d'origine et encapsule l'actionneur piézo-électrique (29) et vient sceller le matériau métallique à mémoire de forme (46) sur les pièces terminales (42, 44).

2. Procédé selon la revendication 1, comprenant d'usiner le matériau métallique à mémoire de forme (46) aux dimensions requises.

3. Procédé selon la revendication 2, comprenant d'usiner le matériau métallique à mémoire de forme (46) jusqu'à une épaisseur de paroi d'environ 1 mm ou moins.

4. Procédé selon la revendication 3, comprenant d'usiner le matériau métallique à mémoire de forme (46) jusqu'à une épaisseur de paroi d'environ 200 à 500 microns.

5. Procédé selon la revendication 1, comprenant d'étirer le tube (46) autour d'un mandrin pour augmenter le diamètre intérieur du tube.

6. Procédé selon la revendication 1 ou 5, comprenant d'étirer le tube (46) pour augmenter le diamètre intérieur d'environ 4 % avant d'être placé par-dessus l'actionneur piézo-électrique (29).

7. Procédé selon la revendication 1, dans lequel l'actionneur piézo-électrique (29) est passivé et dans lequel, par encapsulation de l'actionneur piézo-électrique, le matériau métallique à mémoire de forme (46) isole la passivation (38).

8. Procédé selon l'une quelconque des revendications 1 à 7, comprenant d'appliquer un agent de scellement entre les pièces terminales et le matériau métallique à mémoire de forme (46).

9. Procédé selon l'une quelconque des revendications 1 à 8, dans lequel le matériau métallique à mémoire de forme (46) est un alliage métallique à mémoire de forme.

10. Procédé selon la revendication 9, dans lequel le matériau métallique à mémoire de forme (46) est un alliage nickel-titane comme du NITINOL ®.

11. Actionneur piézo-électrique (29) encapsulé par un matériau métallique à mémoire de forme (46) en accord avec le procédé selon l'une quelconque des revendications précédentes.

12. Injecteur de carburant incorporant l'actionneur piézo-électrique (29) selon la revendication 11.
